Europäisches Patentamt

European Patent Office

Office européen des brevets

(11) Publication number: **0 042 441**
**B1**

(12) **EUROPEAN PATENT SPECIFICATION**

(45) Date of publication of patent specification: 30.01.85

(21) Application number: **81900083.7**

(22) Date of filing: **25.12.80**

(86) International application number:
**PCT/JP80/00328**

(87) International publication number:
**WO 81/01922 09.07.81 Gazette 81/16**

(51) Int. Cl.⁴: **H 03 G 5/02**

(54) **TONE CONTROL CIRCUIT.**

(30) Priority: **29.12.79 JP 170791/79**

(43) Date of publication of application:
**30.12.81 Bulletin 81/52**

(45) Publication of the grant of the patent:
**30.01.85 Bulletin 85/05**

(84) Designated Contracting States:
**DE FR GB NL**

(56) References cited:
**GB-A-1 215 566**
**JP-A-51 033 958**
**US-A-4 045 748**

**IEEE INTERNATIONAL SOLID-STATE CIRCUITS CONFERENCE, DIGEST OF TECHNICAL PAPERS, February 1980 New York, US Conference session XV on 15th February 1980 T. SUGAWARA et al.: "A volume and frequency response control IC for audio"**

(73) Proprietor: **SONY CORPORATION**
**7-35 Kitashinagawa 6-Chome Shinagawa-ku Tokyo 141 (JP)**

(72) Inventor: **OKADA, Takashi**
**1356-111 Kamigou-cho Totsuka-ku Yokohama-shi Kanagawa-ken 247 (JP)**
Inventor: **NAKAJIMA, Hajime**
**2153 Miho-cho Midori-ku Yokohama-shi Kanagawa-ken 226 (JP)**

(74) Representative: **Thomas, Christopher Hugo et al**
**D Young & Co 10 Staple Inn London WC1V 7RD (GB)**

Courier Press, Leamington Spa, England.

## Description

This invention relates to tone control circuits.

Some television broadcasts now use a voice-multiple system to improve the sound quality. It is also required to improve the sound field, and, for the purpose of remote control operation of a television receiver, it is also required that the tone control be effected by a DC voltage. Moreover, as more of the circuitry of television receivers is being made as integrated circuits, it is necessary that the tone control circuit is suitable for contruction as an integrated circuit.

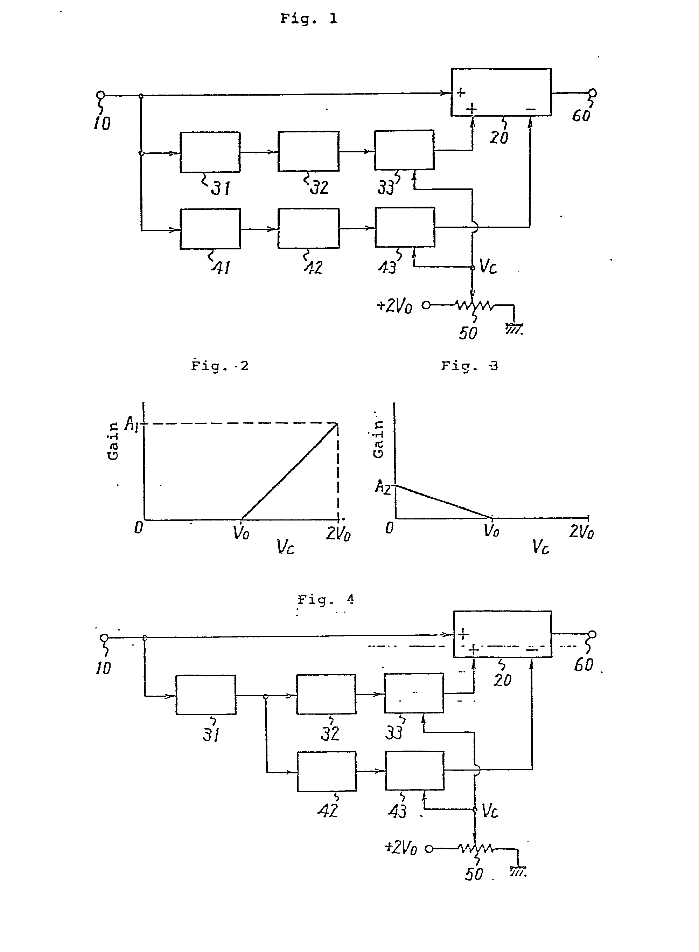

In consideration of these points, we have already proposed a tone control circuit as shown in Figure 1 of the accompanying drawings.

In this proposed tone control circuit an input signal from the input terminal 10 is supplied, as it is, to an adder 20. The input signal from the input terminal 10 is also supplied to a boost signal path comprising a filter 31, an amplifier 32 and a gain control circuit 33, and the output signal therefrom is fed to the adder 20. The input signal from the input terminal 10 is also supplied to a cut signal path comprising a filter 41, an amplifier 42 and a gain control circuit 43, and the output signal therefrom is also supplied to the adder 20. At the adder 20, the signal transmitted through the boost signal path is added to the input signal, and the signal transmitted through the cut signal path is subtracted from the input signal. Thus, an output signal is derived from the adder 20 and supplied to an output terminal 60. A voltage $Vc$ derived from a variable resistor 50 is supplied to the gain control circuits 33 and 43 as the gain control signals.

With this circuit, if the filters 31 and 41 are each a high-pass filter, then boost and cut in a high frequency band can be achieved, while if the filters 31 and 41 are each a low-pass filter, then boost and cut in a low frequency band can be achieved.

That is, when the control voltage $Vc$ is in the range from a centre value $Vo$ to zero, the gain control circuit 33 is set such that its gain is zero. On the contrary, the gain control circuit 43 is set so that when the control voltage $Vc$ is in the range from the centre value $Vo$ to the maximum value $Vo$, its gain becomes zero. Accordingly, when the control voltage $Vc$ is at the centre value $Vo$, the output signals from the gain control circuits 33 and 43 are both zero. Thus, at the output terminal 60 the input signal is obtained unchanged, and the frequency characteristic at this time is flat.

When the control voltage $Vc$ is changed from the centre value $Vo$ fo the maximum value $Vo$, the gain of the gain control circuit 33 increases and becomes unity at the maximum value $Vo$. Accordingly, in this condition, if the gain of the amplifier 32 is taken as $A_1$, as shown in Figure 2 of the accompanying drawings, the gain of the boost signal path becomes $A_1$. Therefore, the boost increases to $A_1 + 1$, where of course $A_1$ is greater than zero.

On the contrary, when the control voltage $Vc$ is changed from the centre value $Vo$ to zero, the gain of the gain control circuit 43 increases and becomes unity at zero. Accordingly, in this condition, if the gain of the amplifier 42 is taken as $A_2$, as shown in Figure 3 of the accompanying drawings, the gain of the cut signal path becomes $A_2$. Therefore, the cut increases $1 - A_2$, where zero is less than $A_2$ is less than or equal to unity. Thus, if $A_2 = 1$, the attenuation can be made infinite.

For boost and cut in the low frequency band, if the filters 31 and 41 are each low-pass filters, the operation of the circuit becomes similar to the above.

With this tone control circuit, since the control curves can be freely set both in the boost and cut directions, a preferred audio characteristic can easily be obtained. Moreover, since the variable resistor 50 has no relation to the constants of the filters 31 and 41 and is controlled by the control voltage $Vc$, the circuit is suitable for remote control.

To simplify the circuit, the filter 31 may be made common to both the boost and the cut signal paths as shown in Figure 4 of the accompanying drawings. When the circuit is to be made as an integrated circuit, this simplification reduces the number of pins for external connection to capacitors to be reduced by one, which reduces the cost.

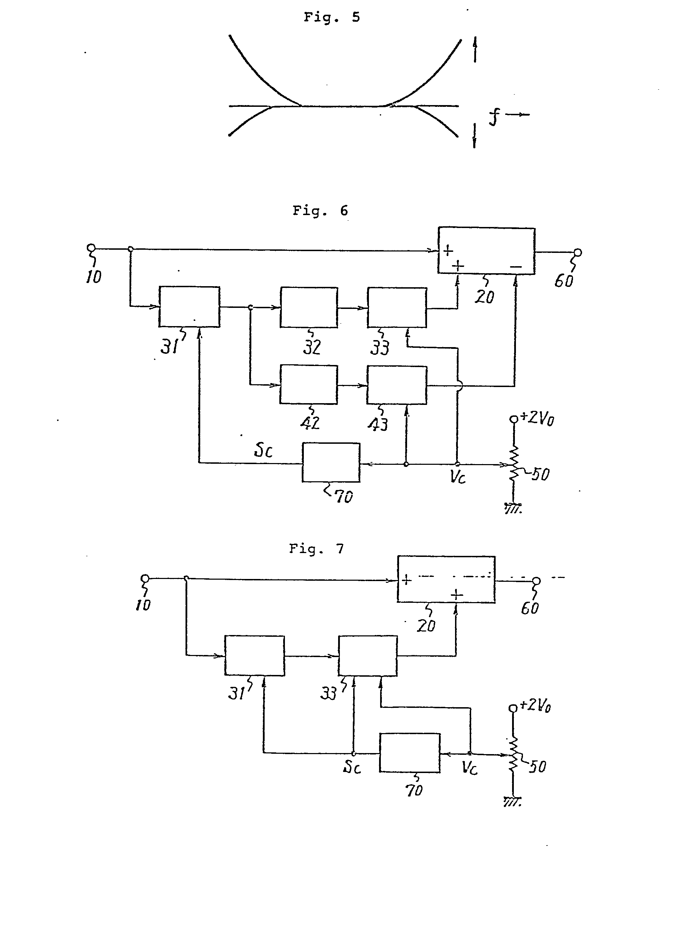

However, if the filter is common to the boost and the cut signal paths the boosting frequency and the cut-off frequency do not coincide on the abscissa of frequency $(f)$, as shown in Figure 5 of the accompanying drawings, because the boost gain and the cut gain are different. This is not preferred, because it makes the audio characteristics less good.

A different form of tone control circuit is disclosed in Japanese patent specification A—51—33958 referred to in the international search. This tone control circuit comprises a first signal path for passing an input audio signal to an adder, and second and third paths including filters and controllable multipliers for passing a derived spectrum of the audio signal to the adder.

According to the present invention there is provided a tone control circuit comprising:

a first signal path for passing an input signal directly to a calculating means;

a second signal path having at least a filter and a gain control circuit;

calculating means for adding a signal from said first signal path to a signal from said second signal path; and

control means for providing DC control voltage for said gain control circuit;

characterized by:

switching means for selecting a boost mode or a cut mode of said tone control circuit in dependence on said control voltage and for switching the frequency characteristic of said second signal path in dependence on said selected mode.

The invention will now be described by way of example with reference to the accompanying drawings, throughout which like parts are referred to by like references, and in which:

Figure 1 is a block diagram of a previously proposed tone control circuit;

Figures 2 and 3 are graphs showing characteristics of the circuit of Figure 1;

Figure 4 is a block diagram of a modified previously proposed tone control circuit;

Figure 5 is a graph showing chracteristics of the circuit of Figure 4;

Figure 6 is a block diagram of an embodiment of tone control circuit according to the invention;

Figure 7 is a block diagram of another embodiment of tone control circuit according to the invention; and

Figure 8 is a circuit diagram of yet another embodiment of tone control circuit according to the invention.

Figure 6 shows an embodiment of tone control circuit according to the invention, in which the control voltage Vc from the variable resistor 50 is fed to a change-over circuit 70 to provide change-over signals Sc which differ between the boost mode and the cut mode. When the voltage Vc is higher than the centre value Vo as set forth above, the circuit is in the boost mode, while when the voltage Vc is lower than the centre value Vo, the circuit is in the cut mode. Therefore, the change-over circuit 70 is constructed such that it compares the control voltage Vc with the reference voltage Vo. The change-over signal Sc is supplied to the filter 31 to change over the time constant of the filter 31 between the boost and cut times. As will be apparent from Figure 5, in the case of the treble, the time constant at the boost mode is selected smaller than that at the cut mode, while in the case of the bass the time constant at the boost mode is selected larger than that at the cut mode.

With the tone control circuit of Figure 6 the cut-off frequency is equivalently shifted in the boost and the cut modes, with consequent improvement in the audio characteristics.

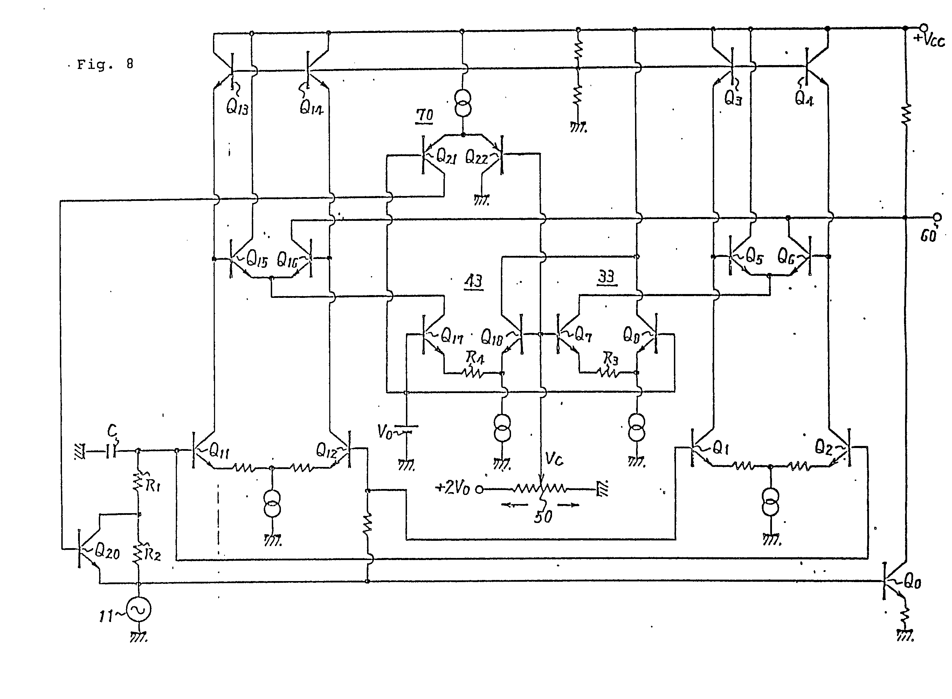

Figure 7 shows another embodiment of the invention. In this embodiment the gain control circuit 33 is common to the boost and the cut signal paths, serves as the amplifier, and is changed over by the change-over signal Sc in both the boost and the cut modes.

That is, in the case of the treble control in the boost mode, the gain of the circuit 33 becomes $A_1$ which is the gain of the above amplifier 32, while in the cut mode the gain of the circuit 33 becomes $A_2$ which is the gain of the above amplifier 42 and also the output becomes opposite in polarity. Since this change-over is carried out when the control voltage Vc is near the centre value Vo and the input signal itself is dominant, no sharp variations are caused.

Figure 8 shows the circuit of an embodiment of the invention and corresponds to the case of the treble control. An input signal from a signal source 11 is supplied, as it is, to a transistor $Q_0$. The block for the high boost is formed of transistors $Q_1$ to $Q_8$, while the block for the high cut is formed of transistors $Q_{11}$ to $Q_{18}$. The change-over circuit 70 comprises transistors $Q_{21}$ and $Q_{22}$.

In the high boost mode where the control voltage Vc is larger than the centre value Vo, the transistor $Q_{21}$ is made ON but the transistor $Q_{22}$ is made OFF. Thus, the transistor $Q_{20}$ becomes ON, so that a filter having a small time constant is formed by a capacitor C and a resistor $R_1$. At this time, the transistors $Q_7$ and $Q_{18}$ are ON and the transistors $Q_8$ and $Q_{17}$ are OFF so that a current flows through the transistor $Q_6$ but no current flows through the transistor $Q_{16}$. And, while the input signal from the signal source 11 is supplied as it is to the base of the transistor $Q_1$, this input signal is supplied to the base of the transistor $Q_2$ through the low-pass filter comprising the capacitor C and the resistor $R_1$. Thus, the low frequency signal components are cancelled and currents corresponding to the high frequency signal components flow to the transistors $Q_1$ and $Q_2$. The signal currents are derived through the transistor $Q_6$, and the high frequency components are added. In this case, the gain is determined by a resistor $R_3$ at the emitter side of the transistor $Q_7$.

While, in the high cut mode where the control voltage Vc is lower than the centre value Vo, the transistor $Q_{21}$ is OFF and the transistor $Q_{22}$ is ON. Thus, a transistor $Q_{22}$ becomes OFF so that a filter having a large time constant is formed by the capacitor C and resistors $R_1$ and $R_2$. At this time, the transistors $Q_8$ and $Q_{17}$ are made ON and the transistors $Q_7$ and $Q_{18}$ are made OFF, so that current flows through the transistor $Q_{16}$ but no current flows through the transistor $Q_6$. And, while the input signal from the signal source 11 is fed, as it is, to the base of the transistor $Q_{12}$, this signal is supplied through the low-pass filter comprising the capacitor C and the resistors $R_1$ and $R_2$, to the base of the transistors $Q_{11}$. Therefore, the currents corresponding to high frequency signal components flow to the transistors $Q_{12}$ and $Q_{11}$. The signal current is then derived through the transistor $Q_{16}$ and hence the high frequency components are subtracted. In this case, the gain is determined by a resistor $R_4$ at the emitter side of the transistor $Q_{17}$.

## Claims

1. A tone control circuit comprising:
a first signal path for passing an input signal directly to a calculating means (20);
a second signal path having at least a filter (31) and a gain control circuit (33, 43);

calculating means (20) for adding a signal from said first signal path to a signal from said second signal path; and

control means (50) for providing DC control voltage for said gain control circuit (33, 43); characterised by:

switching means (70) for selecting a boost mode or a cut mode of said tone control circuit in dependence on said control voltage and for switching the frequency characteristic of said second signal path in dependence on said selected mode.

2. A tone control circuit according to claim 1 wherein the frequency characteristic of said filter (31) is switched in dependence on said selected mode.

3. A tone control circuit according to claim 1 wherein the frequency characteristic of said gain control circuit (33, 43) is switched in dependence on said selected mode.

4. A tone control circuit according to claim 2 wherein the time constant of said filter (31) is switched in dependence on said selected mode.

**Revendications**

1. Circuit de commande de tonalités, comprenant un premier circuit de signal pour faire passer directement un signal d'entrée dans un dispositif calculateur (20); un second circuit de signal comprenant au moins un filtre (31) et un circuit de commande de gain (33, 43); un dispositif calculateur (20) destiné à additionner un signal provenant dudit premier circuit de signal avec un signal provenant dudit second circuit de signal; et un dispositif de commande (50) qui produit une tension continue de commande pour ledit circuit de commande de gain (33, 43); caractérisé par un dispositif de commutation (70) pour sélectionner un mode de renforcement ou un mode de coupure dudit circuit de commande de tonalités en fonction de ladite tension de commande et pour changer la caractéristique de fréquence dudit second circuit de signal en fonction dudit mode sélectionné.

2. Circuit de commande de tonalités selon la revendication 1, dans lequel la caractéristique en fréquence dudit filtre (31) est changée en fonction dudit mode sélectionné.

3. Circuit de commande de tonalités selon la revendication 1, dans lequel la caractéristique en fréquence dudit circuit de commande de gain (33, 43) est changée en fonction dudit mode sélectionné.

4. Circuit de commande de tonalités selon la revendication 2, dans lequel la constante de temps dudit filtre (31) est changée en fonction dudit mode sélectionné.

**Patentansprüche**

1. Klangreglerschaltung mit einem ersten Signalweg für dir direkte Weiterleitung eines Eingangssignals an eine Recheneinrichtung (20),

mit einem zweiten Signalweg, der zumindest ein Filter (31)

und eine Verstärkungssteuerschaltung (33, 43) aufweist, wobei die Recheneinrichtung (20) zur Addition eines Signals von dem genannten ersten Signalweg zu einem Signal von dem genannten zweiten Signalweg dient,

und mit einer Steuereinrichtung (50) zur Bereitstellung einer Steuergleichspannung für die genannte Verstärkungssteuerschaltung (33, 43),

dadurch gekennzeichnet, daß eine Schalteinrichtung (70) vorgesehen ist, die in Abhängigkeit von der genannten Steuerspannung eine Anhebebetrieb oder einen Abschneidebetrieb der Tonreglerschaltung auswählt und die in Abhängigkeit von dem betreffenden ausgewählten Betrieb den Frequenzgang des genannten zweiten Signalweges schaltet.

2. Klangreglerschaltung nach Anspruch 1, wobei der Frequenzgang des genannten Filters (31) in Abhängigkeit von dem ausgewählten Betrieb geschaltet wird.

3. Klangreglerschaltung nach Anspruch 1, wobei der Frequenzgang der Verstärkungssteuerschaltung (33, 43) in Abhängigkeit von dem ausgewählten Betrieb geschaltet wird.

4. Klangreglerschaltung nach Anspruch 2, wobei die Zeitkonstante des Filters (31) in Abhängigkeit von dem ausgewählten betrieb geschaltet wird.

**0 042 441**

Fig. 1

Fig. 2

Fig. 3

Fig. 4

Fig. 5

Fig. 6

Fig. 7

Fig. 8

0042 441